# EUROPÄISCHE PATENTSCHRIFT

(11) **EP 2 206 423 B1**
(45) Veröffentlichungstag und Bekanntmachung des Hinweises auf die Patenterteilung: **06.07.2016**
(21) Anmeldenummer: 08801675.3
(22) Anmeldetag: 22.08.2008
(51) Int. Cl.: B60T 17/22, H01C 1/022, H05K 7/20

(54) **ELEKTROGERÄT**
ELECTRICAL DEVICE
APPAREIL ÉLECTRIQUE

(30) Priorität: 31.10.2007 DE 102007052303
(43) Veröffentlichungstag der Anmeldung: 14.07.2010
(73) Patentinhaber: SEW-EURODRIVE GmbH & Co. KG, 76646 Bruchsal (DE)
(72) Erfinder: MEYER, Harald, 75223 Niefern-Öschelbronn (DE)
(86) Internationale Anmeldenummer: PCT/EP2008/006924
(87) Internationale Veröffentlichungsnummer: WO 2009/056187

(56) Entgegenhaltungen:
- EP-A- 1 376 622
- EP-A- 1 548 907
- WO-A-01/27943
- DE-A1- 19 524 115
- DE-U1- 20 319 891

## Beschreibung

Die Erfindung betrifft ein Elektrogerät.

Es ist bekannt, Drahtwicklungen als Bremswiderstand für generatorisch betreibbare Motoren zu verwenden.

**Aus der** DE 195 24 115 A1 **ist ein Stromrichter bekannt, einen Bremssteller und einen Bremswiderstand in jeweils zueinander separaten Funktionsräumen anzuordnen. Außerdem sollen Isoliermatten zwischen Gehäuseteilen und Innenraum des Stromrichters angeordnet werden.**

**Aus der** EP 1 548 907 A1 **ist bekannt, zur Erlangung der elektrischen Isolation, Kunststoffgehäuse einzusetzen.**

**Aus der** DE 203 19 891 U1 **ist bekannt, dass Bremswiderstände ein Aluminiumgehäuse aufweisen.**

Der Erfindung liegt daher die Aufgabe zugrunde. Antriebe weiterzubilden.

Erfindungsgemäß wird die Aufgabe bei dem Elektrogerät nach den in Anspruch 1 angegebenen Merkmalen gelöst.

**Wichtige** Merkmale der Erfindung bei dem Elektrogerät sind, dass es zumindest einen Bremswiderstand, der ein Bremswiderstandsgehäuse umfasst, umfasst,
wobei das Elektrogerät ein Gehäuse umfasst,
wobei das Bremswiderstandsgehäuse vom Gehäuse des Elektrogeräts umgeben ist, insbesondere gehäusebildend, und elektrisch isoliert gegen das Gehäuse vorgesehen ist,
wobei das Bremswiderstandsgehäuse am Gehäuse des Elektrogeräts befestigt ist.

Von Vorteil ist dabei, dass selbst dann, wenn die Bremswiderstandswicklung nach ihrer Zerstörung eine Verbindung zum Bremswiderstandsgehäuse erzeugt haben sollte, beispielsweise mittels Durchlegieren eines Brems-Choppers, keine Erdströme über das Gehäuse abfließen. Somit ist die Sicherheit erhöht. Da die Wicklung im Bremswiderstandsgehäuse vorgesehen ist, kann selbst bei vorgesehenem Lüfter und von ihm angetriebenem Kühlluftstrom kein Funkenflug erzeugt werden. Außerdem ist mit der Erfindung eine sehr kompakte Einheit realisierbar, da für den Bremswiderstand kein weiteres separates Gehäuse sondern das Gehäuse des Elektrogeräts verwendbar ist.

Bei einer vorteilhaften Ausgestaltung ist zwischen Bremswiderstandsgehäuse und Gehäuse ein Isolierkörper zur elektrischen Isolation vorgesehen. Von Vorteil ist dabei, dass ein einfaches kostengünstiges Mittel zum elektrischen Isolieren und gleichzeitig zum Befestigen vorsehbar ist

Bei einer vorteilhaften Ausgestaltung sind Bremswiderstandsgehäuse und Isolierkörper mittels einer Schraubverbindung verbunden. Von Vorteil ist dabei, dass einfache robuste Mittel verwendbar sind.

Bei einer vorteilhaften Ausgestaltung sind Gehäuse und Isolierkörper mittels einer Schraubverbindung verbunden. Von Vorteil ist dabei, dass die Schraubverbindung nicht durchgehend sein muss sondern die Verbindungskräfte durch den Isolierkörper hindurchgeleitet werden. Auf diese Weise ist eine mechanische Verbindung und ein elektrische Isolation erreichbar mit demselben Mittel.

Bei einer vorteilhaften Ausgestaltung ist ein Kühlluftstrom zur Kühlung des Bremswiderstandsgehäuses vorgesehen. Von Vorteil ist dabei, dass die Entwärmung verbessert ist.

Bei einer vorteilhaften Ausgestaltung ist der Kühlluftstrom durch Konvektion und/oder aktiv durch einen Lüfter erzeugt. Von Vorteil ist dabei, dass einerseits passive Entwärmung, wie konvektive Luftströmung, und andererseits aktive Entwärmung, wie Lüfter-angetriebene Luftströmung, vorsehbar ist.

Bei einer vorteilhaften Ausgestaltung weist das Gehäuse einen Einlass und/oder einen Auslass für den Kühlluftstrom auf. Von Vorteil ist dabei, dass der Luftstrom und somit die Entwärmung an die Umgebung hin vorsehbar ist.

Bei einer vorteilhaften Ausgestaltung weist das Bremswiderstandsgehäuse Kühlrippen auf, insbesondere an denen der Kühlluftstrom vorbeistreicht. Von Vorteil ist dabei, dass die Entwärmung noch effektiver ausführbar ist.

Bei einer vorteilhaften Ausgestaltung umfasst die Leiterplatte einen AC-DC-Wandler, insbesondere einen Gleichrichter und/oder einen Brems-Chopper. Von Vorteil ist dabei, dass die Erfindung bei einer Gleichstrom-Versorgungseinheit vorsehbar ist, deren Verbraucher auch generatorisch betreibbar sind. Somit kann die Gleichspannung auch über einen kritischen Wert ansteigen. Bei Überschreiten des kritischen Wertes ist dann der Bremswiderstand zuschaltbar zur Vernichtung der überschüssigen Energie.

Bei einer vorteilhaften Ausgestaltung umgibt das Bremswiderstandsgehäuse eine Wicklung, die in einem elektrisch isolierenden Material vorgesehen ist. Von Vorteil ist dabei, dass auch bei Explosion oder Schmelzen des Wicklungsdrahtes kein Austreten von Wicklungsteilen in die Umgebung auftritt. Insbesondere schließt das Bremswiderstandsgehäuse die Wicklung und das isolierende Material, beispielsweise ein gepresstes Pulver aus Keramik oder Magnesiumoxid, ein. Außerdem wirkt die Wärmekapazität des isolierenden Materials als Wärmeaufspreizung. Denn kurzfristig auftretende Spitzenwärmeströme strömen in diese Wärmekapazität schnell ein und das Aufbauen hoher Temperaturspitzen wird somit vermieden.

Bei einer vorteilhaften Ausgestaltung umfasst das Material Keramik oder Magnesiumoxid. Von Vorteil ist dabei, dass kostengünstige isolierende und gut wärmeleitende Materialien verwendbar sind.

Bei einer vorteilhaften Ausgestaltung ist das Material als gepresstes Pulver vorgesehen, insbesondere das Material und die von ihm umgebene Wicklung in einen vom Bremswiderstandsgehäuse umgebenen Hohlraum verpresst ist. Von Vorteil ist dabei, dass selbst bei einem Schmelzen oder Explodieren der Wicklung die dabei sich ablösenden Partikel sich nicht weit entfernen können sondern innerhalb des Pulvers, insbesondere aber innerhalb des Hohlraums, verbleiben. Allenfalls eine elektrische Verbindung einer Zuleitung der Wicklung mit dem vorzugsweise metallisch ausgeführten Bremswiderstandsgehäuse kann auftreten.

Bei einer vorteilhaften Ausgestaltung weist die Leiterplatte eine elektronische Schaltung mit der Funktionalität eines Umrichters, Sanftanlaufgeräts oder Versorgungsmoduls auf. Von Vorteil ist dabei, dass generatorisch betriebene Elektromotoren von der Schaltung versorgbar sind. Wenn hierbei eine zu hohe Spannung entsteht, ist diese über den Bremswiderstand reduzierbar.

Bei einer vorteilhaften Ausgestaltung ist das Versorgungsmodul mit Antriebsmodulen elektrisch verbindbar, wobei die vom AC-DC-Wandler erzeugte unipolare Spannung zur Versorgung der Antriebsmodule vorgesehen ist, wobei die Antriebsmodule generatorisch betreibbar sind. Von Vorteil ist dabei, dass eine einzige zentrale Versorgungseinheit über Gleichstromverschienung Antriebsmodule versorgbar macht. Somit ist der Bremswiderstand zusammen mit dem Versorgungsmodul zentral für mehrere Antriebe vorsehbar. Auf diese Weise wird der Bremswiderstand und das Versorgungsmodul entlastet, da die motorisch betriebenen Antriebsmodule Energie der generatorisch betriebenen Antriebsmodule verbrauchen und somit zu hohe Spannungen vermeidbar sind.

Bei einer vorteilhaften Ausgestaltung ist die Wicklung über den Brems-Chopper aus der unipolaren Spannung versorgbar. Von Vorteil ist dabei, dass eine gesteuerte Zufuhr der Energie an die Wicklung ermöglicht ist. Insbesondere ist hierbei ein pulsweitenmodulierter Betrieb des Brems-Choppers ermöglicht.

Bei einer vorteilhaften Ausgestaltung ist der Isolierkörper gut wärmeleitend, insbesondere zur Wärmeabfuhr vom Bremswiderstandsgehäuse an das Gehäuse. Von Vorteil ist dabei, dass auch das Gehäuse zur Wärmeabfuhr verwendbar ist.

Bei einer alternativen vorteilhaften Ausgestaltung ist das Bremswiderstandsgehäuse aus einem elektrisch isolierenden Material vorgesehen. Vorteiligerweise ist somit das Gehäuse direkt mit dem Bremswiderstandsgehäuse verbindbar oder es sind metallische Verbindungsmittel verwendbar, wie beispielsweise Schrauben.

Weitere Vorteile ergeben sich aus den Unteransprüchen.

Die Erfindung wird nun anhand von Abbildungen näher erläutert:

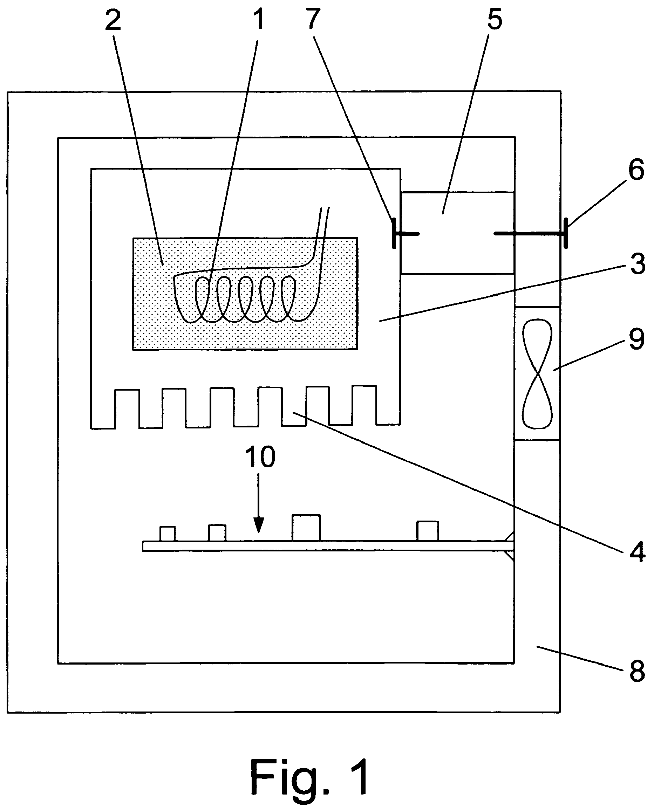

In der Figur 1 ist eine erfindungsgemäße Vorrichtung und in Schnittansicht schematisch skizziert.

Das Gehäuse 8 eines Elektrogeräts, wie Umrichters, AC/DC-Wandler oder dergleichen, umfasst eine Leiterplatte 10 mit elektronischen Bauelement.

Das Elektrogerät ist an ein Wechselspannungsversorgungsnetz angeschlossen und erzeugt aus dieser es versorgenden Wechselspannung eine unipolare Gleichspannung, die mittels eines Zwischenkreiskondensators geglättet wird. Aus dieser werden Wechselrichter versorgt, die jeweils einen Elektromotor speisen. Im generatorischen Betrieb wird Energie vom jeweiligen Motor über den Wechselrichter ins Elektrogerät zurückgeführt, wodurch die unipolare Gleichspannung hohe Werte erreichen kann.

Daher wird bei Überschreiten eines kritischen Wertes der unipolaren Gleichspannung Strom aus dem Zwischenkreis über einen steuerbaren Schalter, den sogenannten Brems-Chopper. einem Bremswiderstand zugeführt. Auf diese Weise ist die überschüssige Energie in ohmsche Wärme umwandelbar.

Bei Versagen den Schalters, beispielsweise Durchkontaktieren, steigt der dem Bremswiderstand zugeführte Strom auf unzulässig hohe Werte und führt zur Zerstörung der Wicklung 1 des Bremswiderstands. Da dieser aber in einem Isolationsmaterial 2, insbesondere Magnesiumoxid, eingebettet, das in einem Bremswiderstandgehäuse 3 vorgesehen ist, sind Explosionen und insbesondere von einem Lüfter angetriebene, austretende Plasmaströme oder entsprechender Funkenflug in die Umgebung hinein vermieden.

Jedoch kann unter Umständen eine elektrische Verbindung zwischen den Resten der Wicklung und dem Bremswiderstandsgehäuse 3 entstehen.

Vorteiligerweise ist aber das Bremswiderstandsgehäuse elektrisch isoliert montiert innerhalb des Elektrogeräts. Hierzu ist das Bremswiderstandsgehäuse 3 mittels
Verbindungsschrauben an dem Isolierkörper 5 angeschraubt und dieser wiederum mittels der Verbindungsschrauben 7 am Gehäuse 8.

Das Bremswiderstandsgehäuse 3 weist Kühlrippen 4 auf, welche von einem von einem Lüfter 9 angetriebenen Luftstrom umspült werden. Auf diese Weise ist eine effiziente Wärmeabfuhr an die Umgebung erreicht. Insbesondere weist das Gehäuse 8 eine Ausnehmung zum Einlass des Luftstroms und eine weitere Ausnehmung zum Auslass des Luftstroms auf.

Das Gehäuse 8 umfasst zumindest auch eine Leiterplatte 10, die mit elektronischen Bauelementen bestückt ist. Insbesondere ist hierbei ein Gleichrichter auf der Leiterplatte realisiert, der aus der Versorgungsnetzspannung eine unipolare Gleichspannung erzeugt, die von einem Kondensator geglättet wird. Außerdem ist der Brems-Chopper in Reihe mit dem Bremswiderstand geschaltet, wobei diese Reihenschaltung aus der Zwischenkreisspannung versorgt wird.

### Bezugszeichenliste

- 1: Wicklung
- 2: Isolationsmaterial
- 3: Bremswiderstandsgehäuse
- 4: Kühlrippen
- 5: Isolierkörper
- 6: Verbindungsschraube
- 7: Verbindungsschraube
- 8: Gehäuse
- 9: Lüfter
- 10: Leiterplatte

## Patentansprüche

1. Elektrogerät, umfassend zumindest einen Bremswiderstand, der ein Bremswiderstandsgehäuse (3) umfasst,
wobei das Elektrogerät ein Gehäuse (8) umfasst,
wobei das Bremswiderstandsgehäuse (3) vom Gehäuse des Elektrogeräts gehäusebildend umgeben ist und elektrisch isoliert gegen das Gehäuse (8) vorgesehen ist,
wobei das Bremswiderstandsgehäuse am Gehäuse des Elektrogeräts befestigt ist.
**wobei zwischen Bremswiderstandsgehäuse und Gehäuse ein aus Keramik gefertigter Isolierkörper (5) zur elektrischen Isolation vorgesehen ist,**
**wobei Bremswiderstandsgehäuse und Isolierkörper mittels einer Schraubverbindung (6,7) verbunden sind,**
**wobei Gehäuse und Isolierkörper mittels einer Schraubverbindung (6,7) verbunden sind, wobei der Isolierkörper gut wärmeleitend ist zur Wärmeabfuhr vom Bremswiderstandsgehäuse an das Gehäuse,**
**wobei im Gehäuse des Elektrogeräts eine Lelterplatte (10) angeordnet ist, die einen AC-DC-Wandler mit Brems-Chopper zur Steuerung der an den Bremswiderstand abzuführenden Energie umfasst,**
**wobei das Gehäuse einen Einlass (9) und/oder einen Auslass für einen Kühlluftstrom aufweist,**
**wobei das Bremswiderstandsgehäuse eine Wicklung (1) umgibt, die in einem elektrisch isolierenden Material vorgesehen Ist,**
**wobei das Material Keramik umfasst,**
**wobei das Material als gepresstes Pulver vorgesehen ist, wobei das Material und die von ihm umgebene Wicklung in einen vom Bremswiderstandsgehäuse umgebenen Hohlraum verpresst ist,**
**wobei die Leiterplatte eine elektronische Schaltung mit der Funktionalität eines Versorgungsmoduls aufweist,**
**wobei das Versorgungsmodul mit Antriebsmodulen elektrisch verbindbar ist, wobei die vom AC-DC-Wandler erzeugte unipolare Spannung zur Versorgung der Antriebsmodule vorgesehen Ist, wobei die Antriebsmodule generatorisch betreibbar sind,**
**wobei die Wicklung über den Brems-Chopper aus der unipolaren Spannung versorgbar ist.**

2. Elektrogerät nach Anspruch 1,
**dadurch gekennzeichnet, dass**
das Bremswiderstandsgehäuse aus einem elektrisch isolierenden Material vorgesehen ist.

3. Elektrogerät nach Anspruch 2,
**dadurch gekennzeichnet, dass**
das elektrisch isolierende Material Keramik und/oder Magnesiumoxid ist oder zumindest umfasst.

4. Elektrogerät nach mindestens einem der vorangegangenen Ansprüche,
**dadurch gekennzeichnet, dass**
ein Kühlluftstrom zur Kühlung des Bremswiderstandsgehäuses vorgesehen ist.

5. Elektrogerät nach mindestens einem der vorangegangenen Ansprüche,
**dadurch gekennzeichnet, dass**
der Kühlluftstrom durch Konvektion und/oder aktiv durch einen Lüfter erzeugt ist.

6. Elektrogerät nach mindestens einem der vorangegangenen Ansprüche,
**dadurch gekennzeichnet, dass**
das Bremswiderstandsgehäuse Kühlrippen aufweist, insbesondere an denen der Kühlluftstrom vorbeistreicht.

## Claims

1. Electrical device, comprising at least one braking resistor which comprises a braking resistor housing (3),
wherein the electrical device comprises a housing (8), wherein the braking resistor housing (3) is surrounded by the housing of the electrical device in a manner forming a housing and is electrically insulated from the housing (8),
wherein the braking resistor housing is fixed to the housing of the electrical device,
wherein an insulating body (5) made of ceramic is provided for electrical insulation between the braking resistor housing and the housing,
wherein the braking resistor housing and the insulating body are connected by means of a screw connection (6, 7),
wherein the housing and the insulating body are connected by means of a screw connection (6, 7),
wherein the insulating body is a good heat conductor for heat removal from the braking resistor housing to the housing,
wherein a circuit board (10) is arranged in the housing of the electrical device, which circuit board comprises an AC-DC converter having a braking chopper for controlling the energy to be removed to the braking resistor,
wherein the housing has an inlet (9) and/or an outlet for a cooling air flow,
wherein the braking resistor housing surrounds a winding (1) which is provided in an electrically insulating material,
wherein the material comprises ceramic,
wherein the material is provided as a pressed powder, the material and the winding surrounded by it being pressed into a hollow space surrounded by the braking resistor housing,
wherein the circuit board has an electronic circuit with the functionality of a supply module,
wherein the supply module is electrically connectable to drive modules, the unipolar voltage, generated by the AC-DC converter, being provided for supplying the drive modules, the drive modules being generatively operable,
wherein the winding is suppliable via the braking chopper from the unipolar voltage.

2. Electrical device according to claim 1,
**characterised in that**
the braking resistor housing is made of an electrically insulating material.

3. Electrical device according to claim 2,
**characterised in that**
the electrically insulating material is or at least comprises ceramic and/or magnesium oxide.

4. Electrical device according to at least one of the preceding claims,
**characterised in that**
a cooling air flow is provided for cooling the braking resistor housing.

5. Electrical device according to at least one of the preceding claims,
**characterised in that**
the cooling air flow is generated by convection and/or actively by a fan.

6. Electrical device according to at least one of the preceding claims,
**characterised in that**
the braking resistor housing has cooling ribs, in particular which the cooling air flow sweeps past.

## Revendications

1. Appareil électrique équipé d'au moins une résistance de freinage dotée d'un boîtier (3),
ledit appareil électrique incluant un carter (8),
le boîtier (3) de la résistance de freinage étant entouré par le carter de l'appareil électrique, avec formation d'un caisson, et étant prévu avec isolation électrique par rapport audit carter (8),
ledit boîtier de la résistance de freinage étant fixé audit carter dudit appareil électrique, un corps isolant (5), fabriqué en céramique, étant prévu entre ledit carter et ledit boîtier de la résistance de freinage, afin d'instaurer l'isolation électrique,
ledit boîtier de la résistance de freinage, et ledit corps isolant, étant reliés au moyen d'une solidarisation vissée (6, 7),
ledit carter, et ledit corps isolant, étant reliés au moyen d'une solidarisation vissée (6, 7), ledit corps isolant étant doué d'une bonne conductivité thermique, en vue de la dissipation de chaleur vers ledit carter à partir dudit boîtier de la résistance de freinage,
une plaquette (10) à circuit imprimé, logée dans ledit carter de l'appareil électrique, comportant un convertisseur CA/CC muni d'un hacheur de freinage, en vue de commander l'énergie devant être cédée à la résistance de freinage,
ledit carter étant pourvu d'une admission (9) et/ou d'une sortie destinée(s) à un courant d'air de refroidissement,
ledit boîtier de la résistance de freinage entourant un enroulement (1) prévu dans un matériau électriquement isolant,
lequel matériau inclut de la céramique,
ledit matériau étant prévu sous la forme d'une poudre comprimée, sachant que ledit matériau, et l'enroulement entouré par ce dernier, sont pressés dans une cavité cernée par ledit boîtier de la résistance de freinage,
ladite plaquette à circuit imprimé présentant un circuit électronique doté de la fonctionnalité d'un module d'alimentation,
ledit module d'alimentation pouvant être connecté électriquement à des modules d'entraînement, sachant que la tension unipolaire, engendrée par le convertisseur CA/CC, est prévue pour alimenter lesdits modules d'entraînement, lesquels modules d'entraînement peuvent être actionnés en mode générateur,
l'enroulement pouvant être alimenté sur la base de la tension unipolaire, par l'intermédiaire du hacheur de freinage.

2. Appareil électrique selon la revendication 1,
**caractérisé par le fait que**
le boîtier de la résistance de freinage est prévu en un matériau électriquement isolant.

3. Appareil électrique selon la revendication 2,
**caractérisé par le fait que**
le matériau électriquement isolant consiste en de la céramique et/ou en de l'oxyde de magnésium, ou inclut au moins cette substance.

4. Appareil électrique selon au moins l'une des revendications précédentes,
**caractérisé par le fait**
**qu'**un courant d'air de refroidissement est prévu pour refroidir le boîtier de la résistance de freinage.

5. Appareil électrique selon au moins l'une des revendications précédentes,
**caractérisé par le fait que**
le courant d'air de refroidissement est engendré par convection, et/ou activement par l'intermédiaire d'un ventilateur.

6. Appareil électrique selon au moins l'une des revendications précédentes,
**caractérisé par le fait que**
le boîtier de la résistance de freinage présente des ailettes de refroidissement balayées, en particulier, par le courant d'air de refroidissement.
